# FASCICULE DE BREVET EUROPEEN

(11) **EP 1 937 875 B1**
(45) Date de publication et mention de la délivrance du brevet: **06.03.2019**
(21) Numéro de dépôt: 06831203.2
(22) Date de dépôt: 20.09.2006
(51) Int. Cl.: C25D 5/24, H01L 21/288

(54) **COMPOSITION D'ELECTRODEPOSITION DESTINEE AU REVETEMENT D'UNE SURFACE D'UN SUBSTRAT PAR UN METAL**
GALVANISIERZUSAMMENSETZUNG ZUM BESCHICHTEN EINER SUBSTRATOBERFLÄCHE MIT EINEM METALL
ELECTROPLATING COMPOSITION FOR COATING A SUBSTRATE SURFACE WITH A METAL

(30) Priorité: 20.09.2005 FR 0509571
(43) Date de publication de la demande: 02.07.2008
(73) Titulaire: aveni, 91300 Massy (FR)
(72) Inventeur: DAVIOT, Jérôme, F-92160 Antony (FR); GONZALEZ, José, F-75019 Paris (FR)
(74) Mandataire: Chantraine, Sylvie Hélène
(86) Numéro de dépôt international: PCT/FR2006/050914
(87) Numéro de publication internationale: WO 2007/034116

(56) Documents cités:
- EP-A- 0 611 840
- US-A1- 2001 042 689
- US-A1- 2005 006 245

## Description

La présente invention concerne généralement une composition d'électrodéposition destinée au revêtement d'une surface d'un substrat par du cuivre, notamment d'une surface constituée d'un matériau électriquement résistif, et en particulier au revêtement d'une couche barrière de diffusion au cuivre.

L'invention trouve notamment application dans le domaine de la microélectronique pour la fabrication d'éléments d'interconnexion dans des circuits intégrés. Elle trouve également application dans d'autres domaines de l'électronique pour la fabrication d'éléments d'interconnexion dans des circuits imprimés (dénommés « Printed Circuit Board » ou « Printed Wire Board » en anglais) ou celle d'éléments passifs, tels que les inductances, ou électromécaniques dans des circuits intégrés ou des microsystèmes (dénommés « Micro Electro Mechanical Systems » en anglais).

Par électrodéposition on entend ici un procédé qui permet de recouvrir une surface d'un substrat par un revêtement métallique ou organométallique, dans lequel le substrat est polarisé électriquement et mis au contact d'un liquide contenant des précurseurs dudit revêtement métallique ou organométallique, de manière à former ledit revêtement. Lorsque le substrat est conducteur de l'électricité, l'électrodéposition est par exemple réalisée par passage d'un courant entre le substrat à revêtir constituant une électrode (la cathode dans le cas d'un revêtement métallique ou organométallique) et une seconde électrode (l'anode) dans un bain contenant une source de précurseurs du matériau de revêtement (par exemple des ions métalliques dans le cas d'un revêtement métallique) et éventuellement divers agents destinés à améliorer les propriétés du revêtement formé (régularité et finesse du dépôt, résistivité, etc.), éventuellement en présence d'une électrode de référence. Par convention internationale le courant et la tension passant ou appliqué au substrat d'intérêt, c'est-à-dire à la cathode du circuit électrochimique, sont négatifs. Dans l'ensemble de ce texte, lorsque ces courants et tensions sont mentionnés par une valeur positive, il est implicite que cette valeur représente la valeur absolue dudit courant ou de ladite tension.

L'électrodéposition de cuivre est notamment utilisée dans le domaine de la microélectronique pour la fabrication d'éléments d'interconnexion dans des circuits intégrés. La bonne conductivité électrique du cuivre et sa résistance élevée au phénomène d'électromigration, c'est-à-dire la faible migration des atomes de cuivre sous l'effet de la densité de courant électrique susceptible de déformer significativement le conducteur et d'être une cause importante de défaillance, en font en particulier un matériau de choix pour la fabrication d'interconnexions métalliques pour des circuits intégrés présentant des dimensions de gravure de plus en plus fines.

Les circuits intégrés sont généralement fabriqués par formation de dispositifs semiconducteurs actifs, notamment des transistors, à la surface de plaquettes de silicium (dénommées "Wafers" en anglais), lesdits dispositifs semiconducteurs étant reliés entre eux par un système d'interconnexions métalliques formé de "lignes" et de "contacts" encore dénommés "vias" disposés en niveaux superposés et obtenus par remplissage respectivement de "tranchées" et de "puits" encore dénommés "trous d'interconnexion" pratiqués dans les couches diélectriques.

Le cuivre étant difficile à graver et présentant un haut pouvoir de diffusion dans de nombreux matériaux, les éléments d'interconnexion sont généralement réalisés par une succession d'étapes comportant :
- le dépôt d'une couche diélectrique isolante ;
- la gravure des motifs d'interconnexion dans ladite couche diélectrique ;
- le dépôt d'une couche barrière (généralement constituée de tantale, nitrure de titane, nitrure de tantale, nitrure ou carbure de tungstène, par exemple) servant à empêcher la migration du cuivre ;
- le remplissage des lignes et des trous d'interconnexion par du cuivre ; et
- l'élimination du cuivre en excès par polissage mécano-chimique.

Cette succession d'étapes est connue sous le nom de "procédé Damascène", lequel a été décrit par exemple dans : Chang, C. Y. and Sze, S. M., "ULSI Technology" McGraw-Hill, New York, (1996), pages 444-445.

La couche barrière présente généralement une résistance trop élevée pour permettre, par voie électrochimique, un dépôt de cuivre homogène ou uniforme à l'échelle de la plaquette, phénomène connu de l'homme de l'art sous le terme de chute ohmique. La résistance élevée de la couche barrière résulte à la fois de la résistivité élevée des matériaux la constituant (généralement nitrures métalliques) et de sa faible épaisseur (généralement de quelques nm à quelques dizaines de nm selon la génération de circuits intégrés) laquelle épaisseur est imposée par la faible dimension des motifs d'interconnexion.

De ce fait, il est généralement nécessaire, préalablement à l'étape d'électrodéposition du cuivre, de recouvrir la couche barrière - par une méthode non électrochimique - d'une mince couche de cuivre métallique, appelée couche de germination ("seed layer" en anglais). Cette couche de germination, comme la couche barrière, est actuellement réalisée par des procédés de dépôt physique ou chimique à partir d'une phase vapeur (PVD ou "Physical Vapor Deposition et CVD ou "Chemical Vapor Deposition" en anglais, respectivement).

Compte tenu des dimensions critiques des lignes et des trous d'interconnexion des circuits intégrés actuels, et de leur évolution vers des dimensions de plus en plus réduites, l'épaisseur des couches de germination de cuivre est à l'heure actuelle de l'ordre de 30 nm, et devrait rapidement évoluer vers 10 nm ou moins.

Le dépôt chimique en phase vapeur (CVD) permet d'obtenir une couche de cuivre conforme, c'est-à-dire épousant fidèlement la topographie de la surface à revêtir, et ceci pour une large gamme de facteurs de forme (« aspect ratio » en anglais). Cependant, les couches de cuivre formées par dépôt chimique en phase vapeur présentent une adhérence médiocre sur les barrières de diffusion. Ceci limite en pratique l'intérêt de ce type de procédé dans la mesure où une forte adhérence entre le cuivre et la barrière est requise afin d'assurer la fiabilité des structures constituant les interconnexions.

De plus, les procédés utilisant un dépôt chimique en phase vapeur sont relativement coûteux en raison du prix élevé des consommables (précurseurs), de l'équipement nécessaire à leur mise en oeuvre et de leur faible rendement.

Le dépôt physique en phase vapeur (PVD) est actuellement préféré d'un point de vue industriel dans la mesure où il permet de revêtir des surfaces ayant une résistivité élevée avec une adhérence du cuivre sur la barrière bien meilleure que celle obtenue avec les procédés de type CVD.

L'épaisseur du revêtement déposé par PVD est directement proportionnelle à l'angle solide vu de la surface à revêtir. De ce fait, les parties de la surface présentant des angles saillants sont recouvertes d'une couche plus épaisse que les parties de la surface présentant des angles rentrants. Il en résulte que les couches de germination de cuivre formées par dépôt physique en phase vapeur ne sont pas conformes, et ne présentent donc pas une épaisseur uniforme en tout point de la surface du substrat. On observe en particulier des phénomènes dits de surplomb ou d'ombre (ou d' « overhang » en anglais) aux arêtes supérieures des tranchées ou des vias, allant jusqu'à obstruer leur ouverture, et rendant impossible leur remplissage ultérieur. Par ailleurs, les flancs des tranchées et des vias peuvent être recouverts d'une épaisseur insuffisante de couche de germination, provoquant alors un remplissage ultérieur imparfait présentant des défauts de matière (appelées « voids » en anglais). De plus, la couche de germination réalisée sur les flancs des motifs présente par nature une adhérence différente de celle déposée sur la surface plane du substrat (haut et fond des tranchées et des vias). Ceci peut conduire à des performances de fiabilité, telles que la résistance à l'électromigration, amoindries. En d'autres termes, le défaut de conformité ne se révèle pas seulement par des différences d'épaisseur ; des défauts de continuité et d'adhérence de la couche sur les flancs des tranchées et des vias peuvent aussi en résulter.

Ces inconvénients rendent très délicat l'emploi de la technologie PVD dans les générations avancées de circuits intégrés où les dimensions transversales des tranchées et des vias sont très faibles (de l'ordre de quelques dizaines de nanomètres) et où les facteurs de forme peuvent être importants.

Dans ce contexte, la technique d'électrodéposition présentée ici constitue une alternative avantageuse aux procédés de dépôt chimique ou physique en phase vapeur, ainsi même qu'aux techniques d'électrodéposition de métaux plus traditionnelles, qui ne peuvent pas opérer sur des substrats résistifs.

En effet, l'électrodéposition traditionnelle, qui consiste à appliquer un courant en général continu au substrat plongé dans un bain d'ions métalliques ne peut être appliquée qu'aux seules surfaces suffisamment conductrices c'est-à-dire présentant typiquement une résistance carrée inférieure à quelques ohm/carré environ, ce qui n'est pas le cas des couches formant barrière de diffusion au cuivre pour les technologies les plus avancées, dont la résistance carrée est couramment de plusieurs dizaines d'ohm/carré à plusieurs centaines d'ohm/carré et peut être de plusieurs dizaines de milliers d'ohm/carré.

La résistance carrée (« sheet résistance » en anglais) est une grandeur utilisée par l'homme de l'art mesurant la résistance électrique des couches minces. Elle est exprimée en ohm/carré et elle est équivalente à la résistivité pour un système bidimensionnel, c'est-à-dire dans lequel le courant circule dans le plan de la couche et non dans un plan perpendiculaire à cette couche. Mathématiquement, on obtient la valeur de la résistance carrée en divisant la résistivité du matériau (exprimée en ohm.m ou micro-ohm.cm) constitutif de la couche par l'épaisseur de cette couche (exprimée en m ou nm).

A ce jour, l'électrodéposition traditionnelle de cuivre est principalement utilisée pour le remplissage des tranchées et des puits dans le procédé Damascène, par application d'un courant continu à un wafer préalablement couvert d'une couche de germination et plongé dans un bain acide de sulfate de cuivre contenant des additifs. Ce procédé de remplissage des tranchées et puits par du cuivre métallique est notamment décrit dans Rosenberg et al., in "Copper metalization for high performance silicon technology", Ann. Rev. Mater. Sci (2000), 30, 229-62.

Une utilisation de l'électrodéposition de cuivre sur une couche de germination de cuivre pour le remplissage des tranchées et des puits a également été décrite dans le brevet US 6 893 550 incorporé ici par référence.

Le procédé d'électrodéposition décrit dans le document US 6 893 550 est essentiellement caractérisé :
- d'une part, en ce qu'il fait appel à un bain d'électrodéposition dont la composition chimique spécifique comprend au moins un acide, de préférence l'acide sulfurique, au moins un ion halogénure, de préférence chlorure et une combinaison d'agents chimiques susceptibles d'accélérer ou de ralentir la formation du revêtement ; et
- d'autre part, en ce qu'il consiste à modifier la densité du courant appliqué selon des séquences prédéterminées.

Une électrodéposition de cuivre a également été préconisée, notamment par le brevet US 6 811 675 pour combler d'éventuels vides dans la couche de germination ou pour réparer cette couche ("seed repair" ou "seed enhancement" en anglais).

Dans un mode de réalisation préféré décrit dans ce document antérieur, on réalise dans une première étape, de préférence par un procédé de dépôt physique à partir d'une phase vapeur, une couche de germination en cuivre « ultra fine » non uniforme (épaisseur de l'ordre de 20 nanomètres) puis dans une deuxième étape, on améliore la conformité de la couche par électrodéposition à l'aide d'une solution alcaline (dont le pH est supérieur à 9) d'électrodéposition qui comprend du sulfate de cuivre, un agent complexant du cuivre, de préférence l'acide citrique, et éventuellement de l'acide borique pour améliorer la brillance du revêtement et/ou du sulfate d'ammonium pour réduire la résistivité du revêtement. La densité du courant appliqué lors de l'électrodéposition est comprise entre 1 mA/cm² et 5 mA/cm².

Il est indiqué dans ce document antérieur que ce procédé d'électrodéposition peut-être également utilisé pour réaliser une couche de germination en cuivre, mais cette possibilité n'est illustrée par aucun exemple et parait difficilement réalisable, en raison des densités de courant élevées mentionnées dans ce document.
Il a été proposé dans le document EP 611 840 des solutions d'électrodéposition de cuivre exemptes de cyanure essentiellement destinées au dépôt d'une couche de cuivre ou d'argent sur une plaque d'acier. Ces solutions contiennent un complexe du métal avec des ions thiosulfates ; elles sont stabilisées avec un sulfinate organique et peuvent comprendre un additif triéthanolamine pour améliorer ou augmenter les performances de la solution pendant le dépôt électrolytique. L'amine ne se complexe pas avec le cuivre dans cette composition..
Des compositions d'électrodéposition contenant un complexe de cuivre avec des citrates ou des borates en milieu acide ont été décrites dans le document US 2005/0006245. Cependant l'épaisseur des couches de germination déposées sont élevées (de l'ordre de 100 nm) et la demanderesse a mis en évidence que leur adhésion sur des supports de haute résistivité insuffisante.

Dans ces conditions, la présente invention a pour but de résoudre le nouveau problème technique consistant en la fourniture d'une nouvelle composition d'électrodéposition permettant notamment de réaliser des couches de germination en cuivre continues et conformes, d'une épaisseur de l'ordre de 10 nm ou moins et présentant une excellente adhésion sur des surfaces de barrière de diffusion pouvant avoir une résistivité élevée jusqu'à quelques méga ohm/carré.

La solution conforme à la présente invention pour résoudre ce problème technique consiste en une composition d'électrodéposition destinée notamment à revêtir une couche barrière de diffusion au cuivre dans la fabrication d'interconnexions pour des circuits intégrés, caractérisée en ce qu'elle comprend, en solution dans un solvant :
- une source d'ions du cuivre, en une concentration comprise entre 0,4 et 15 mM ;
- au moins un agent complexant du cuivre choisi parmi les amines aromatiques et les hétérocycles azotés;
- le rapport molaire entre le cuivre et les agents complexants étant compris entre 0,1 et 2,5;
- le pH de ladite composition étant inférieur à 7.

Il a été découvert, et ceci constitue le fondement de la présente invention que certains agents complexants du cuivre utilisés en milieu acide, c'est-à-dire à un pH inférieur à 7, permettaient d'obtenir des compositions d'électrodéposition du cuivre particulièrement remarquables, susceptibles d'être utilisées pour la réalisation de couches de germination en cuivre continues et conformes directement sur des surfaces de barrière de diffusion telles que celles employées dans la fabrication d'interconnexions de circuits intégrés.

Cette découverte est d'autant plus surprenante que l'homme du métier sait que les composés comportant un atome d'azote, et en particulier les amines, peuvent être protonés en milieu acide, en perdant ainsi leur aptitude à former des complexes avec le cuivre. D'une façon tout à fait surprenante, il a ainsi été constaté que la déposition du cuivre sur une couche de barrière s'effectuait d'une manière beaucoup plus satisfaisante en milieu acide où la proportion du cuivre complexé est à priori plus faible qu'en milieu basique comme préconisé dans l'état de la technique.

Il a été constaté que d'excellents résultats pouvaient être obtenus avec les agents complexants capables d'être adsorbés sur une surface métallique en conduisant à des couches ordonnées. De tels agents sont la pyridine et la 2, 2' bipyridine pris en mélanges, en particulier des mélanges dans lesquels le rapport molaire entre la pyridine et la 2,2' bipyridine est compris entre 5:1 et 1:5, de préférence entre 3:1 et 1:1, de préférence encore voisin de 2:1.
Bien qu'il n'y ait pas de restriction de principe sur la nature du solvant (pourvu qu'il solubilise suffisamment les espèces actives de la solution et n'interfère pas avec l'électrodéposition), il s'agira de préférence d'eau ou d'une solution hydroalcoolique.

D'une façon générale, la composition d'électrodéposition selon l'invention comprend une source d'ions du cuivre, en particulier d'ions cuivriques Cu2+.

Avantageusement, la source d'ions du cuivre est un sel de cuivre tel qu'en particulier le sulfate de cuivre, le chlorure de cuivre, le nitrate de cuivre, l'acétate de cuivre, de préférence le sulfate de cuivre.

La source d'ions du cuivre est présente au sein de la composition d'électrodéposition en une concentration comprise entre 0,4 et 15 mM. D'excellents résultats ont été obtenus avec des compositions dans lesquelles la source d'ions du cuivre est présente en une concentration comprise entre 0,5 et 4 mM.

Dans la composition d'électrodéposition selon l'invention, le rapport molaire entre la source d'ions du cuivre et les agents complexants du cuivre est compris entre 0,1 et 2,5, de préférence entre 0,3 et 1,3.

D'une façon générale, la composition d'électrodéposition selon l'invention présente un pH inférieur à 7, de préférence compris entre 3,5 et 6,5.

Le pH de la composition peut éventuellement être ajusté dans la gamme de pH précitée au moyen d'un tampon tel que l'un de ceux décrits dans : « Handbook of chemistry and physics - 84th edition » David R. Lide, CRC Press

Une composition d'électrodéposition actuellement préférée, selon l'invention, comprend, en solution aqueuse :
- du sulfate de cuivre, en une concentration comprise entre 0,4 et 15 mM;
- un mélange de pyridine et de 2,2' bipyridine en tant qu'agents complexants du cuivre ;
- le rapport molaire entre le cuivre et les agents complexants étant compris entre 0,3 et 1,3 ;
- le pH de ladite composition étant inférieur à 7, de préférence compris entre 3,5 et 6,5.

Les compositions d'électrodéposition selon la présente invention peuvent être mises en oeuvre dans un procédé usuel d'électrodéposition comportant la mise en contact de la surface d'un substrat, tel qu'en particulier une couche barrière de diffusion au cuivre, avec une composition d'électrodéposition selon l'invention et une étape de formation d'un revêtement sur ladite surface du substrat au cours de laquelle ladite surface est polarisée pendant une durée suffisante pour former ledit revêtement.

Des modes de réalisation impliquant des protocoles de potentiel ou de courant plus spécifiques peuvent être préférés lorsque l'on recherche des revêtements ayant des spécifications particulières, et notamment des revêtements fins (épaisseur inférieure à 20 nm, et de préférence inférieure à 10 nm), adhérents, conformes et uniformes.

Il a été observé, de façon surprenante, que d'excellents résultats en la matière peuvent être obtenus à l'aide de la composition d'électrodéposition selon l'invention en contrôlant, lors du procédé d'électrodéposition, les conditions de mise en contact de la surface à revêtir avec ladite composition (ou bain) d'électrodéposition préalablement à la formation du revêtement et les conditions de séparation de cette surface de ladite composition d'électrodéposition après formation du revêtement.

Il a été observé, de façon tout à fait inattendue, qu'il était possible, avec les compositions d'électrodéposition précitées, d'améliorer l'adhérence entre la couche de revêtement de cuivre réalisée par électrodéposition et la couche barrière, en mettant la surface à revêtir au contact de la composition d'électrodéposition sans polarisation électrique, c'est-à-dire sans imposer de courant électrique ou de potentiel électrique par rapport à une contre-électrode ou par rapport à une électrode de référence à cette surface, préalablement à l'étape d'électrodéposition.

Une amélioration encore plus importante de cette adhérence a été observée lorsque la surface du substrat à revêtir est maintenue au contact de la composition d'électrodéposition pendant une durée d'au moins 5 secondes après cette mise en contact et toujours préalablement à l'étape d'électrodéposition.

Il a été constaté que l'amélioration de l'adhérence de la couche de germination sur la couche barrière permet, de façon surprenante, d'améliorer l'adhésion de l'ensemble « couche de germination / couche de remplissage ou cuivre épais ou couche épaisse », c'est-à-dire l'adhérence « opérationnelle » de l'assemblage pour lequel la couche de germination est réalisée.

Il est en général difficile de mesurer directement l'adhésion d'une couche de germination seule, notamment du fait de sa faible épaisseur mais les résultats obtenus ont montré que l'adhésion des couches de germination réalisées selon la présente invention est manifestement très élevée. L'énergie d'adhésion de l'ensemble « couche de germination / couche de remplissage ou cuivre épais ou couche épaisse » sur la couche barrière, qui est la propriété opérationnelle d'intérêt que l'on cherche effectivement à optimiser, est plus aisée et utile d'évaluer. On peut par exemple évaluer cette adhésion par pelage (« peeling » en anglais) d'un ruban adhésif collé sur la surface supérieure de l'assemblage par exemple par l'emploi d'une machine d'essai ou de traction. L'adhésion ainsi mesurée, ou énergie d'interface exprimée en J/m², caractérise globalement à la fois l'adhérence de la couche de germination sur la barrière et celle de la couche épaisse de cuivre sur la couche de germination. Elle ne donne pas de renseignement précis sur l'une ou l'autre interface, mais permet de quantifier la propriété opérationnelle recherchée, à savoir la solidité de l'interface cuivre/barrière. De ce fait, dans la présente description, on parlera ainsi indifféremment de l'adhésion de la couche de germination, de l'adhésion de la couche épaisse de cuivre sur la couche de germination, ou de la solidité de l'interface cuivre/barrière après remplissage.

Il a en outre été observé, de façon surprenante, qu'il était possible d'obtenir une couche de germination présentant une conductivité compatible avec les procédés de remplissage par électrodéposition traditionnelle, en maintenant sous polarisation électrique la surface revêtue, de préférence pendant une durée comprise entre 1 et 10 secondes, de préférence pendant une durée comprise entre 1 et 5 secondes après sa séparation de la composition d'électrodéposition.

Ainsi, les compositions d'électrodéposition selon l'invention seront de préférence mises en oeuvre dans un procédé d'électrodéposition comprenant :
- une étape dite d'« entrée à froid » au cours de laquelle ladite surface à revêtir est mise en contact sans polarisation électrique avec un bain d'électrodéposition et de préférence maintenue dans cet état pendant une durée d'au moins 5 secondes, de préférence comprise entre 10 et 60 secondes, et de préférence encore d'environ 10 à 30 secondes ;
- une étape de formation du revêtement au cours de laquelle ladite surface est polarisée pendant une durée suffisante pour former ledit revêtement ;
- une étape dite de « sortie à chaud » au cours de laquelle ladite surface est séparée du bain d'électrodéposition tandis qu'elle est encore sous polarisation électrique.

La combinaison d'une étape d'entrée à froid et d'une étape de sortie à chaud dans ce procédé permet d'obtenir dans des conditions facilitées et reproductibles une meilleure adhésion de l'ensemble « couche de germination / cuivre de remplissage ».

Dans ce procédé, l'étape de formation du revêtement par électrodéposition est conduite pendant une durée suffisante pour former le revêtement souhaité. Cette durée peut être facilement déterminée par l'homme du métier, la croissance du film étant fonction de la charge qui est égale à l'intégrale temporelle du courant électrique passé dans le circuit pendant le temps du dépôt (loi de Faraday).

Au cours de l'étape de formation du revêtement, la surface à revêtir est polarisée, soit en mode galvanostatique (courant imposé fixe), soit en mode potentiostatique (potentiel imposé et fixe, éventuellement par rapport à une électrode de référence), soit encore en mode pulsé (en courant ou en tension).

Une combinaison de ces modes est également possible comme par exemple une étape en mode potentiostatique suivie d'une étape en mode galvanostatique.

D'une façon générale, un revêtement satisfaisant peut être obtenu par polarisation en mode galvanostatique, de préférence dans une gamme de courant de 0,1 mA/cm² (milli-Ampère par centimètre carré) à 5 mA/cm², et plus particulièrement de 0,1 mA/cm² à 1 mA/cm².

Un revêtement satisfaisant peut également être obtenu par polarisation en mode potentiostatique, en imposant une tension de cellule de manière à ce que le courant de cellule résultant soit dans la même gamme de courant qu'indiquée précédemment (0,1 mA/cm² à 5 mA/cm², et plus particulièrement de 0,1 mA/cm² à 1 mA/cm²). Bien que la tension de cellule dépende en particulier de paramètres de conception de la cellule tels que la distance à la contre-électrode ou la présence d'une membrane, elle sera facilement déterminée par l'homme de l'art en mesurant et en ajustant le courant obtenu pour un potentiel et une configuration donnés.

Un revêtement satisfaisant peut encore être obtenu par polarisation en mode pulsé, de préférence de manière à imposer des créneaux de tension.

D'une façon générale, cette étape peut être réalisée en imposant des créneaux de tension correspondants à un courant par unité de surface maximum dans une gamme de 0,1 mA/cm² à 5 mA/cm², et plus particulièrement de 0,1 mA/cm² à 1 mA/cm² et à un courant par unité de surface minimum dans une gamme de 0 mA/cm² à 0,5 mA/cm², et plus particulièrement de 0 mA/cm² à 0,1 mA/cm².

Plus particulièrement, la durée de polarisation à la tension maximum peut être comprise entre 0,15 et 5 secondes, par exemple de l'ordre de deux secondes pour une tension correspondant à un courant par unité de surface maximum de l'ordre de 0,5 mA/cm², tandis que la durée de polarisation à la tension minimum peut être comprise entre 0,15 et 7 secondes, par exemple de l'ordre de 3 secondes pour une tension correspondant à un courant par unité de surface minimum de l'ordre de 0,05 mA/cm².

Le nombre de cycles à réaliser au cours de cette étape dépend de l'épaisseur souhaitée du revêtement.

D'une façon générale l'homme du métier déterminera aisément le nombre de cycles à réaliser sachant que dans les conditions générales précitées, et illustrées par les exemples de réalisation, il a été observé que la vitesse de dépôt est d'environ 0,1 nm par cycle.

Ce dernier mode de mise en oeuvre de l'invention a permis en particulier de réaliser des couches de germination de cuivre sur des substrats très résistifs, dont la résistance carrée peut atteindre 100 000 ohm/carré, voire même quelques méga ohm/carré.

L'étape de « sortie à chaud » précitée est avantageusement réalisée en mode potentiostatique, c'est-à-dire en maintenant à une valeur fixe le potentiel électrique du substrat revêtu (wafer) mesuré soit par rapport à la contre-électrode du circuit, soit par rapport à une électrode de référence, de préférence au même niveau de tension que lors de l'étape de dépôt du revêtement lorsque celle-ci est également réalisée en mode potentiostatique.

Selon un second aspect, la présente invention a pour objet l'utilisation des compositions d'électrodéposition décrites précédemment pour revêtir une couche de barrière de diffusion au cuivre dans la fabrication d'interconnexions pour des circuits intégrés.

Sous cet aspect, la présente invention couvre également un procédé de revêtement d'une surface d'un substrat, tel qu'en particulier une couche barrière de diffusion au cuivre, qui comprend la mise en contact de ladite surface avec une composition d'électrodéposition telle que décrite précédemment et une étape au cours de laquelle ladite surface est polarisée pendant une durée suffisante pour former ledit revêtement.

Selon une caractéristique particulière, la surface formant barrière de diffusion au cuivre comprend au moins l'un des matériaux choisis parmi le nitrure de tantale, le tantale, le ruthénium, le cobalt, le tungstène, le nitrure de titanium, des surfaces formant barrière particulières étant constituées d'une bicouche nitrure de tantale/tantale ou d'une couche de ruthénium.

Ce procédé de revêtement est particulièrement utile pour la réalisation d'une couche de germination de cuivre présentant une épaisseur très faible pouvant être de l'ordre de 30 nm ou moins, par exemple de l'ordre de 10 nm ou moins, sur une surface formant barrière de diffusion au cuivre telle que définie précédemment.

La présente invention va maintenant être illustrée par les exemples non limitatifs suivants dans lesquels les compositions selon l'invention (exemples 1,3,6 et 7) sont utilisées pour réaliser le dépôt d'une couche de germination de cuivre sur des substrats de silicium revêtus d'une couche barrière de diffusion au cuivre. Ces exemples trouvent notamment application dans la fabrication de structures d'interconnexion en cuivre pour circuits intégrés.

### EXEMPLE 1 : Préparation d'une couche de germination de cuivre sur une couche barrière TaN/Ta à l'aide d'une composition selon l'invention à base d'un mélange de 2,2' bipyridine et de pyridine.

### A. Matériel et équipement

### Substrat :

Le substrat utilisé dans cet exemple est constitué d'une plaque de silicium de 200 mm de diamètre, recouverte d'une couche de silice ayant une épaisseur de 400 nm elle-même revêtue d'une couche de nitrure de tantale (TaN) ayant une épaisseur de 15 nm déposée par pulvérisation réactive et d'une couche de tantale (Ta) ayant une épaisseur de 10 nm déposée par pulvérisation.

Cette « bi-couche » TaN/Ta constitue une barrière de diffusion au cuivre telle qu'utilisée dans les structures dites « double damascène » dans la fabrication des interconnexions en cuivre des circuits intégrés.

### Solution d'électrodéposition :

La solution d'électrodéposition mise en oeuvre dans cet exemple est une solution aqueuse contenant 0,3 g/l (ou 1,7 mM) de 2,2' bipyridine, 0,6 g/l (ou 2,4 mM) de CuSO₄(H₂O)₅ et 0,3 ml/l (ou 3,3 mM) de pyridine.

Le pH de la solution est compris entre 5,8 et 6,2.

### Equipement :

Dans cet exemple, on a utilisé un équipement de dépôt électrolytique représentatif de ceux employés dans l'industrie microélectronique de marque Semitool® et de type Equinox™ capable de traiter des plaques de 200 mm de diamètre.

Cet équipement comporte une cellule de dépôt éléctrolytique dans laquelle est réalisé le dépôt de la couche de germination et une station de rinçage/séchage utilisée après dépôt.

La cellule de dépôt électrolytique comporte une anode qui peut être constituée soit en un métal inerte (titane recouvert de platine par exemple), soit en un métal identique à celui constituant la couche de germination, en l'occurrence du cuivre ; la plaque de silicium revêtue par la couche barrière TaN/Ta, constituant la cathode de cette cellule.

Cette cellule comporte en outre une alimentation électrique stabilisée permettant de fournir jusqu'à 30 V et 4 A et un dispositif de mise en contact électrique de la cathode physiquement isolé de la solution par un joint d'étanchéité. Ce dispositif de mise en contact électrique est généralement de forme annulaire et permet une alimentation du substrat en plusieurs points de contacts disposés de manière régulière sur celui-ci.

Elle comporte également un dispositif de support de la plaque à revêtir comportant des moyens de mise en rotation de la dite plaque à vitesse prédéterminée.

### B. Protocole expérimental

Le procédé d'électrodéposition mis en oeuvre dans cet exemple comporte les différentes étapes consécutives suivantes.

### Etape 1 : « Entrée à froid »

Cette étape peut être décomposée en deux sous étapes :
1.1. Le substrat précité est introduit dans la cellule de dépôt électrolytique de façon à ce que la face comportant la couche barrière TaN/Ta vienne au contact du dispositif de mise en contact électrique, ce dernier n'étant toujours pas alimenté électriquement.
1.2. L'ensemble formé par le dispositif de mise en contact électrique et le substrat, qui sera dénommé par la suite « ensemble cathodique » est mis en contact, par exemple par trempage, avec la solution d'électrodéposition. Cette mise en contact, dont la durée est généralement inférieure ou égale à 5 secondes (par exemple 2 secondes) est réalisée alors que le dispositif n'est toujours pas alimenté électriquement. De préférence, l'ensemble cathodique est alors maintenu dans la solution d'électrodéposition sans polarisation pendant une durée d'au moins 5 secondes (par exemple de l'ordre de 30 secondes).

### Etape 2 : Formation du revêtement de cuivre

L'ensemble cathodique est alors polarisé en mode potentiostatique en imposant une tension de cellule correspondant à un courant par unité de surface généralement compris entre 0,4 mA/cm² et 0,8 mA/cm² (par exemple 0,6 mA/cm²) et simultanément mis en rotation à une vitesse de 20 à 60 tours par minutes (40 tours par minute par exemple).

La durée de cette étape dépend, comme on le comprend, de l'épaisseur souhaitée de la couche de germination. Cette durée peut être facilement déterminée par l'homme du métier, la croissance du film étant fonction de la charge passée dans le circuit.

Dans les conditions précitées, la vitesse de dépôt est d'environ 1nm par coulomb de charge passée dans le circuit.

Dans cet exemple, la durée de l'étape d'électrodéposition a été de l'ordre de 50 secondes pour obtenir un revêtement ayant une épaisseur de 10 nm et de l'ordre de 200 secondes pour obtenir un revêtement ayant une épaisseur de 40 nm.

### Etape 3 : « Sortie à chaud »

Cette étape peut être décomposée en deux sous étapes :
3.1. Après l'étape d'électrodéposition, l'ensemble cathodique revêtu de cuivre est retiré de la solution d'électrodéposition à vitesse de rotation nulle en étant maintenu sous polarisation en tension. La durée de cette phase est d'environ 2 secondes.

La vitesse de rotation est alors portée à 500 tours par minute pendant 10 secondes, la polarisation de l'ensemble cathodique étant coupée pendant cette dernière phase.

Un pré-rinçage à l'eau dé-ionisée est effectué dans la cellule.
3.2. Le substrat revêtu de la couche de germination est alors transféré dans le module de rinçage/séchage pour subir un rinçage à l'eau dé-ionisée.

L'eau de rinçage est alors évacuée puis un séchage sous balayage d'azote est réalisé.

La rotation est alors stoppée pour permettre le retrait du substrat revêtu et séché.

Dans cet exemple, l'étape de sortie et en particulier le retrait de l'ensemble cathodique de la solution d'électrodéposition a été effectué sous polarisation en tension au même niveau que durant l'étape de formation du dépôt.

### C. Résultats obtenus

En appliquant le protocole expérimental exposé ci-dessus, on a obtenu des couches de cuivre de 10 nm, 20 nm et 40 nm d'épaisseur présentant d'excellentes caractéristiques de conformité, d'adhésion et de résistance.

La conformité a été évaluée à partir d'observations en coupe au microscope électronique à balayage et en comparant l'épaisseur de la couche de germination sur les surfaces horizontales avec celle sur les surfaces verticales.

La résistance carrée a été mesurée à l'aide d'un appareil de type mesure « 4 pointes » bien connu de l'homme du métier.

L'adhésion ou énergie d'interface a été mesurée après dépôt électrochimique d'une couche de 500 nm de cuivre (dite couche de « plating ») sur la couche de germination. Cette mesure a été effectuée à l'aide d'un dispositif (dit machine d'essai ou de traction) qui exerce une force de tension verticale croissante sur la surface par l'intermédiaire d'un ruban adhésif puissant jusqu'à ce que la couche de cuivre (couche de germination et couche de plating) se sépare du substrat. Le travail de cette force (force multipliée par longueur de la couche qui a délaminé) équivaut à l'énergie qu'il a fallu fournir pour séparer la couche de cuivre de son substrat. En divisant cette énergie par la valeur de la surface qui a délaminé, on obtient l'énergie par unité de surface.

Une partie des résultats des mesures réalisées a été reportée dans le tableau 1 ci-dessous.

### EXEMPLE 2 : Préparation d'une couche de germination de cuivre sur une couche barrière TaN/Ta à l'aide d'une composition à base de 2,2' bipyridine.

### A. Matériel et équipement

### Substrat :

Le substrat utilisé dans cet exemple est constitué d'un coupon de silicium ayant une longueur de 6 cm et une largeur de 2 cm, recouvert d'une couche de silice ayant une épaisseur de 400 nm elle-même revêtue d'une couche de nitrure de tantale (TaN) ayant une épaisseur de 15 nm déposée par pulvérisation réactive et d'une couche de tantale (Ta) ayant une épaisseur de 10 nm déposée par pulvérisation.

Cette « bi-couche » TaN/Ta constitue une barrière de diffusion au cuivre telle qu'utilisée dans les structures dites « double damascène » dans la fabrication des interconnexions en cuivre des circuits intégrés.

### Solution d'électrodéposition :

La solution d'électrodéposition mise en oeuvre dans cet exemple est une solution aqueuse contenant du CuSO₄(H₂O)₅ et de la 2,2' bipyridine.

Dans cette solution, le rapport molaire entre le cuivre et l'agent complexant (la 2,2' bipyridine) peut varier entre 0,1 et 2,5 (par exemple 1,4) en partant d'une concentration de CuSO₄(H₂O)₅ de 0,2 g/l (ou 0,8 mM) par exemple.

Le pH de la solution est compris entre 4,5 et 5.

### Equipement :

Dans cet exemple, on utilise une cellule de dépôt éléctrolytique en verre composée de deux parties : la cellule destinée à contenir la solution d'électrodéposition, et un « capot » qui permet de maintenir les différentes électrodes en position d'utilisation.

La cellule de dépôt électrolytique comporte trois électrodes :
- une anode en métal inerte (platine),
- le coupon de silicium revêtu de la couche TaN/Ta, qui constitue la cathode,
- une électrode de référence Ag/AgClO₄.

Des connecteurs permettent la mise en contact électrique des électrodes qui sont reliés par des fils électriques à un potentiostat fournissant jusqu'à 10 V et 2 A.

### B. Protocole expérimental

Le procédé d'électrodéposition mis en oeuvre dans cet exemple comporte les différentes étapes consécutives suivantes.

### Etape 1 : « Entrée à chaud »

La solution d'électrodéposition est versée dans la cellule.

On met en place les différentes électrodes sur le capot de la cellule électrolytique.

Les électrodes sont mises en contact sous polarisation avec la solution d'électrodéposition.

### Etape 2 : Formation du revêtement de cuivre

La cathode est polarisée soit en mode galvanostatique dans une gamme de courant de 1 mA (ou 0,125 mA/cm²) à 4 mA (ou 0,5 mA/cm²) (par exemple 2 mA (ou 0,25 mA/cm²)), soit en mode potentiostatique dans une gamme de potentiel de 2 V à 5 V (par exemple 2 V), soit en mode voltamétrie cyclique avec une rampe de potentiels allant dans une gamme de potentiels de 2 V à 5 V (par exemple 2V), une vitesse de balayage comprise entre 20 et 500 mV/s (par exemple 50 mV/s), et un nombre de cycles compris entre 2 et 10 (par exemple 2).

Un dégazage à l'argon peut être employé ; il permet d'avoir une certaine hydrodynamique dans la cellule.

La durée de cette étape dépend du mode électrochimique de dépôt utilisé (galvanostatique ou voltamétrie cyclique). Elle est généralement comprise entre 2 et 15 minutes. Pour un même mode de dépôt, cette durée dépend de l'épaisseur souhaitée de la couche de germination et peut être facilement déterminée par l'homme du métier, la croissance du film étant fonction de la charge passée dans le circuit.

Dans les conditions précitées, la vitesse de dépôt est d'environ 31nm par coulomb de charge passée dans le circuit.

Dans cet exemple, la durée de l'étape d'électrodéposition en mode voltamétrie cyclique a été de l'ordre de 480 s pour obtenir un revêtement ayant une épaisseur de 30 nm.

### Etape 3 : « Sortie à froid »

La polarisation est coupée, les électrodes étant toujours en contact avec la solution.

La cathode est alors déconnectée, et rincée abondamment à l'eau dé-ionisée 18 MΩ, puis séchée à l'aide d'un pistolet délivrant de l'argon à une pression de l'ordre de 2 bars.

### C. Résultats obtenus

En appliquant le protocole expérimental décrit ci-dessus en mode voltamétrie cyclique on a obtenu des couches de cuivre continues et conformes (observation au microscope électronique à balayage) de 20 nm, 30 nm et 40 nm d'épaisseur.

La couche de germination de cuivre ayant une épaisseur de 30 nm présente une résistance carrée de 4 ohm/carré, mesurée par la méthode décrite à l'exemple 1.

### EXEMPLE 3 : Préparation d'une couche de germination de cuivre sur une couche barrière TaN/Ta à l'aide d'une composition selon l'invention à base d'un mélange de 2,2' bipyridine et de pyridine.

### A. Matériel et équipement

### Substrat :

Le substrat utilisé dans cet exemple est identique à celui de l'exemple 2.

### Solution :

La solution mise en oeuvre dans cet exemple est une solution aqueuse contenant de la 2,2' bipyridine, de la pyridine et du CuSO₄(H₂O)₅. Le rapport molaire entre le cuivre et les complexants (la 2,2' bipyridine, et la pyridine) peut varier entre 0,1 et 2,5 (par exemple 0,5) en partant d'une concentration de CuSO₄(H₂O)₅ de 0,2 g/l (ou 0,8 mM) par exemple, pour des concentrations massiques des deux complexants du même ordre de grandeur.

Le pH de la solution est compris entre 5,8 et 6,2.

### Equipement :

L'équipement utilisé dans cet exemple est identique à celui de l'exemple 2.

### B. Protocole expérimental

Le protocole utilisé dans cet exemple est identique à celui de l'exemple 2.

### C. Résultats obtenus

En appliquant ce protocole expérimental en mode voltamétrie cyclique on a obtenu des couches de cuivre continues et conformes (observation au microscope électronique à balayage) de 10 nm, 20 nm et 40 nm d'épaisseur.

Les couches de germination de cuivre ayant une épaisseur de 20 nm et 10 nm présentent une résistance carrée de 8 ohm/carré, respectivement 18 ohm/carré, mesurée par la méthode décrite à l'exemple 1.

### EXEMPLE 4 : Préparation d'une couche de germination de cuivre sur une couche barrière TaN/Ta à l'aide d'une composition à base d'un dérivé de la pyridine.

### A. Matériel et équipement

### Substrat :

Le substrat utilisé dans cet exemple est identique à celui de l'exemple 2.

### Solution :

La solution mise en oeuvre dans cet exemple est une solution aqueuse contenant de la 3,5-diméthyl pyridine et du CuSO₄(H₂O)₅. Le rapport molaire entre le cuivre et l'agent complexant (la 3,5-diméthyl pyridine) peut varier entre 0,1 et 2,5 (par exemple 1) en partant d'une concentration de CuSO₄(H₂O)₅ de 0,2 g/l (ou 0,8 mM) par exemple.

Le pH de la solution est compris entre 4,5 et 5.

### Equipement :

L'équipement utilisé dans cet exemple est identique à celui de l'exemple 2.

### B. Protocole expérimental

Le protocole utilisé dans cet exemple est identique à celui de l'exemple 2.

### C. Résultats obtenus

En appliquant ce protocole expérimental en mode galvanostatique on a obtenu des couches de cuivre continues et conformes (observation au microscope électronique à balayage) de 25 nm et 35 nm d'épaisseur.

Les couches de germination de cuivre ayant une épaisseur de 25 nm et 35 nm présentent une résistance carrée de 5 ohm/carré, respectivement 4 ohm/carré, mesurée par la méthode décrite à l' exemple 1.

### EXEMPLE 5 comparatif: Préparation d'une couche de germination de cuivre sur une couche barrière TaN/Ta à l'aide d'une composition à base d'une polyamine aliphatique.

### A. Matériel et équipement

### Substrat :

Le substrat utilisé dans cet exemple est identique à celui de l'exemple 2.

### Solution :

La solution mise en oeuvre dans cet exemple est une solution aqueuse contenant de la tétraéthylpentamine à la concentration de 0,36 g/l (ou 1,9 mM) et du CuSO₄(H₂O)₅ à la concentration de 0,6 g/l (ou 2,4 mM). Le rapport molaire entre le cuivre et l'agent complexant (la tétraéthylpentamine) est de 1,26 mais peut varier entre 0,1 et 2,5 en partant d'une concentration de CuSO₄(H₂O)₅ de 0,6 g/l par exemple.

Le pH de la solution est de 5,1.

### Equipement :

L'équipement utilisé dans cet exemple est identique à celui de l'exemple 2.

### B. Protocole expérimental

Le procédé d'électrodéposition mis en oeuvre dans cet exemple comporte les différentes étapes consécutives suivantes.

### Etape 1 : « Entrée à froid »

La solution d'électrodéposition est versée dans la cellule.

On met en place les différentes électrodes sur le capot de la cellule électrolytique.

Les électrodes sont mises en contact avec la solution d'électrodéposition. A ce stade, l'ensemble ainsi formé n'est toujours pas polarisé électriquement (il est à son potentiel de circuit ouvert).

L'ensemble est maintenu dans cet état (c'est-à-dire sans polarisation électrique) pendant une durée de 10 à 60 secondes (par exemple 30 secondes).

### Etape 2 : Formation du revêtement de cuivre

La cathode est polarisée en mode galvanostatique dans une gamme de courant de 2 mA (ou 0,25 mA/cm²) à 8 mA (ou 1 mA/cm²) (par exemple 6 mA (ou 0,75 mA/cm²)).

Un dégazage à l'argon peut être employé ; il permet d'avoir une certaine hydrodynamique dans la cellule.

La durée de cette étape dépend de l'épaisseur souhaitée de la couche de germination et peut être facilement déterminée par l'homme du métier, la croissance du film étant fonction de la charge passée dans le circuit.

Dans les conditions précitées, la vitesse de dépôt est d'environ 33 nm par coulomb de charge passée dans le circuit.

Dans cet exemple, la durée de l'étape d'électrodéposition a été de l'ordre de 200 secondes pour obtenir un revêtement ayant une épaisseur de l'ordre de 40 nm.

### Etape 3 : « Sortie à chaud »

La cathode est alors séparée de la solution, la polarisation étant toujours appliquée.

La cathode est alors déconnectée, et rincée abondamment à l'eau dé-ionisée 18 MΩ, puis séchée à l'aide d'un pistolet délivrant de l'argon à une pression de l'ordre de 2 bars.

### C. Résultats obtenus

En appliquant le protocole expérimental décrit ci-dessus on a obtenu des couches de cuivre continues et conformes (observation au microscope électronique à balayage) de 30 nm et 40 nm d'épaisseur.

La couche de germination de cuivre ayant une épaisseur de 40 nm présente une résistance carrée de 8 ohm/carré, mesurée par la méthode décrite à l'exemple 1.

### EXEMPLE 6 : Préparation d'une couche de germination de cuivre sur une couche barrière Ru à l'aide d'une composition selon l'invention à base d'un mélange de 2,2' bipyridine et de pyridine.

### Substrat :

Le substrat utilisé dans cet exemple est constitué d'un coupon de silicium ayant une longueur de 6 cm et une largeur de 2 cm, recouvert d'une couche de silice ayant une épaisseur de 400 nm elle-même revêtue d'une couche de ruthénium (Ru) ayant une épaisseur de 30 nm déposée par pulvérisation. La résistance carrée de ce substrat est de 7,5 ohm/carré.

Cette couche de Ru peut constituer une barrière de diffusion au cuivre telle qu'utilisée dans les structures dites "double damascène" dans la fabrication des interconnexions en couvre des circuits intégrés avancés.

### Solution :

La solution mise en oeuvre dans cet exemple est identique à celle de l'exemple 1.

### Equipement :

L'équipement utilisé dans cet exemple est identique à celui de l'exemple 2.

### B. Protocole expérimental

Le procédé d'électrodéposition mis en oeuvre dans cet exemple est identique à celui de l'exemple 5.

### C. Résultats obtenus

En appliquant le protocole expérimental décrit ci-dessus on a obtenu une couche de cuivre continue et conforme (observation au microscope électronique à balayage) de 40 nm d'épaisseur.

Cette couche de germination de cuivre présente une résistance carrée de 2,5 ohm/carré, mesurée par la méthode décrite à l'exemple 1.

### EXEMPLE 7 : Préparation d'une couche de germination de cuivre sur une couche barrière TaN/Ta à l'aide d'une composition selon l'invention à base d'un mélange de 2,2' bipyridine et de pyridine.

### A. Matériel et équipement

### Substrat :

Le substrat utilisé dans cet exemple est identique à celui utilisé à l'exemple 1.

### Solution d'électrodéposition :

La solution d'électrodéposition mise en oeuvre dans cet exemple est une solution aqueuse (eau dé-ionisée18,2 Mohm.cm) préparée en salle propre (classe 10000 ou ISO 7) contenant 0,4 g/l (ou 2,56 mM) de 2,2' bipyridine de pureté 99,7% commercialisé par la société Oxkem, 0,8 g/l (ou 3,2 mM) de CuSO₄(H₂O)₅ de pureté 99,995% commercialisé par la société Alfa Aesar et 0,367 ml/l (ou 4 mM) de pyridine de pureté 99,9% commercialisée par la société Aldrich.

La solution est filtrée à l'aide d'un filtre de taille 0,2µm après sa fabrication.

Le pH de la solution est 5,94.

### Equipement :

L'équipement utilisé dans cet exemple est identique à celui utilisé à l'exemple 1.

### B. Protocole expérimental

Le procédé d'électrodéposition mis en oeuvre dans cet exemple est identique à celui de l'exemple 1.

### C. Résultats obtenus

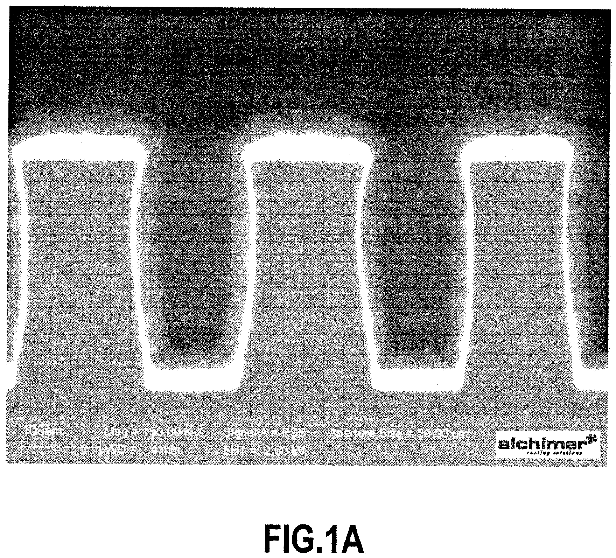

En appliquant le protocole expérimental exposé ci-dessus, on a obtenu des couches de cuivre de 10 nm et 20 nm d'épaisseur présentant d'excellentes caractéristiques de conformité (voir figures 1a. et 1b. ci-dessous), d'adhésion et de résistance.

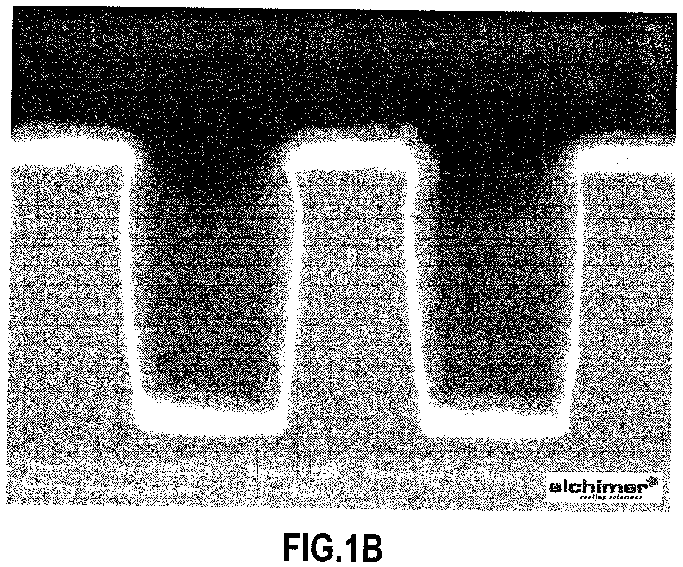

Les excellentes caractéristiques de conformité de ce revêtement sont illustrées par les figures 1a et 1b qui représentent une vue en coupe en imagerie d'électrons rétrodiffusés permettant de visualiser le contraste chimique.

La conformité sur tranchées a aussi été caractérisée à plus grande échelle (0,01 mm²) par scattérométrie. Ces mesures ont montré une épaisseur de cuivre sur le haut, le bas et les flancs des tranchées de 7 nm, en accord avec les épaisseurs observées en coupe MEB.

Hormis la scattérométrie, les méthodes de caractérisation utilisées dans cet exemple sont identiques à celles de l'exemple 1.

Le tableau 1 ci-dessous rassemble les résultats obtenus aux exemples 1 à 7 qui précèdent. Des tendances similaires sont également observées pour une résistance carrée avant traitement pouvant être de plusieurs centaines d'ohm/carré, voire plusieurs dizaines de milliers d'ohm/carré, voire encore jusqu'à quelques méga ohm/carré.

**TABLEAU 1**

| Couche de germination de cuivre obtenue selon | Epaisseur (nm) | Résistance carrée (ohm/carré) | | Adhésion (J/m²) |
|---|---|---|---|---|
| | | Avant traitement | Après traitement | |
| Exemple 1 | 20 | 23 | 8 | 11 à 13 |
| Exemple 1 | 10 | 23 | 18 | 11 à 13 |
| Exemple 2 | 30 | 23 | 4 | 3 à 5 |
| Exemple 3 | 20 | 23 | 8 | 5 à 7 |
| Exemple 3 | 10 | 23 | 18 | 5 à 7 |
| Exemple 4 | 25 | 23 | 4 | 1 à 3 |
| Exemple 4 | 35 | 23 | 5 | 1 à 3 |
| Exemple 5 comparatif | 40 | 23 | 8 | < 1 |
| Exemple 6 | 40 | 7,5 | 2,5 | > 20 |
| Exemple 7 | 20 | 22 | 5,3 | > 20 |
| Exemple 7 | 10 | 21 | 15 | > 20 |

## Revendications

1. Composition d'électrodéposition destinée notamment à revêtir une couche barrière de diffusion au cuivre dans la fabrication d'interconnexions pour des circuits intégrés, **caractérisée en ce qu'**elle comprend, en solution dans un solvant :
- une source d'ions du cuivre, en une concentration comprise entre 0,4 et 15 mM ;
- un mélange de pyridine et de 2,2' bipyridine en tant qu'agents complexants du cuivre;
- le rapport molaire entre le cuivre et les agents complexants étant compris entre 0,1 et 2,5;
- le pH de ladite composition étant inférieur à 7.

2. Composition d'électrodéposition selon la revendication 1, **caractérisée en ce que** le solvant précité est choisi parmi l'eau et les solutions hydroalcooliques.

3. Composition d'électrodéposition selon la revendication 1 ou 2, **caractérisée en ce que** la source d'ions du cuivre précitée est un sel de cuivre tel qu'en particulier le sulfate de cuivre, le chlorure de cuivre, le nitrate de cuivre, l'acétate de cuivre, de préférence le sulfate de cuivre.

4. Composition d'électrodéposition selon l'une des revendications 1 à 3, **caractérisée en ce que** le rapport molaire entre le cuivre et les agents complexants est compris entre un 0,3 et 1,3.

5. Composition d'électrodéposition selon l'une des revendications 1 à 4, **caractérisée en ce que** le pH de ladite composition est compris entre 3,5 et 6,5.

6. Utilisation d'une composition d'électrodéposition selon l'une des revendications 1 à 5, pour revêtir une couche barrière de diffusion au cuivre dans la fabrication d'interconnexions pour des circuits intégrés.

## Patentansprüche

1. Galvanisierzusammensetzung, die insbesondere zum Beschichten einer Kupferdiffusionssperrschicht bei der Herstellung von Verbindungen für integrierte Schaltungen bestimmt ist, **dadurch gekennzeichnet, dass** sie in Lösung in einem Lösungsmittel umfasst:
- eine Kupferionenquelle in einer Konzentration zwischen 0,4 und 15 mM,
- eine Mischung aus Pyridin und 2,2' Bipyridin als Kupferkomplexbildner,
- wobei das Molverhältnis zwischen dem Kupfer und den Komplexbildnern zwischen 0,1 und 2,5 liegt,
- wobei der pH-Wert der Zusammensetzung kleiner als 7 ist.

2. Galvanisierzusammensetzung nach Anspruch 1, **dadurch gekennzeichnet, dass** das Lösungsmittel unter Wasser und hydroalkoholischen Lösungen ausgewählt ist.

3. Galvanisierzusammensetzung nach Anspruch 1 oder 2, **dadurch gekennzeichnet, dass** es sich bei der Kupferionenquelle um ein Kupfersalz handelt, wie insbesondere Kupfersulfat, Kupferchlorid, Kupfernitrat, Kupferacetat, vorzugsweise Kupfersulfat.

4. Galvanisierzusammensetzung nach einem der Ansprüche 1 bis 3, **dadurch gekennzeichnet, dass** das Molverhältnis zwischen dem Kupfer und den Komplexbildnern zwischen 0,3 und 1,3 liegt.

5. Galvanisierzusammensetzung nach einem der Ansprüche 1 bis 4, **dadurch gekennzeichnet, dass** der pH-Wert der Zusammensetzung zwischen 3,5 und 6,5 liegt.

6. Verwendung einer Galvanisierzusammensetzung nach einem der Ansprüche 1 bis 5 zum Beschichten einer Kupferdiffusionssperrschicht bei der Herstellung von Verbindungen für integrierte Schaltungen.

## Claims

1. Electroplating composition intended in particular for coating a copper-diffusion barrier layer in the fabrication of interconnects for integrated circuits, **characterized in that** it comprises, in solution in a solvent:
- a source of copper ions, in a concentration of between a mixture of pyridine and 2,2'-bipyridine as copper complexing agents;
- the copper/complexing agent(s) molar ratio being between 0.1 and 2.5; and
- the pH of the said composition being less than 7.

2. Electroplating composition according to Claim 1, **characterized in that** the abovementioned solvent is chosen from water and hydroalcoholic mixtures.

3. Electroplating composition according to Claim 1 or 2, **characterized in that** the aforementioned source of copper ions is a copper salt, such as in particular copper sulphate, copper chloride, copper nitrate or copper acetate, preferably copper sulphate.

4. Electroplating composition according to one of claims 1 to 3, **characterized in that** the copper/complexing agents molar ratio is between 0.3 and 1.3.

5. Electroplating composition according to one of claims 1 to 4, **characterized in that** the pH of the said composition is between 3.5 and 6.5.

6. Use of an electroplating composition according to one of Claims 1 to 5 for coating a copper-diffusion barrier layer in the fabrication of interconnects for integrated circuits.
